Europäisches Patentamt

European Patent Office

Office européen des brevets

(19)

(11) **EP 0 655 164 B1**

(12) **EUROPÄISCHE PATENTSCHRIFT**

(45) Veröffentlichungstag und Bekanntmachung des Hinweises auf die Patenterteilung:
**11.11.1998 Patentblatt 1998/46**

(21) Anmeldenummer: **94913504.0**

(22) Anmeldetag: **06.05.1994**

(51) Int Cl.⁶: **G11C 29/00**, G11C 8/00

(86) Internationale Anmeldenummer:
**PCT/DE94/00521**

(87) Internationale Veröffentlichungsnummer:
**WO 94/28555 (08.12.1994 Gazette 1994/27)**

(54) **SELBSTTESTEINRICHTUNG FÜR SPEICHERANORDNUNGEN, DECODER ODER DGL.**

SELF-TESTING DEVICE FOR STORAGE ARRANGEMENTS, DECODERS OR THE LIKE

DISPOSITIF DE CONTROLE AUTOMATIQUE POUR ENSEMBLES DE MEMOIRES, DECODEURS OU ANALOGUES

(84) Benannte Vertragsstaaten:
**DE FR GB IT**

(30) Priorität: **22.05.1993 DE 4317175**

(43) Veröffentlichungstag der Anmeldung:
**31.05.1995 Patentblatt 1995/22**

(73) Patentinhaber: **ROBERT BOSCH GMBH**
**70442 Stuttgart (DE)**

(72) Erfinder:
• **BOEHL, Eberhard**
**D-72760 Reutlingen (DE)**
• **KESEL, Frank**
**D-72766 Reutlingen (DE)**

(56) Entgegenhaltungen:
**EP-A- 0 162 428**      **US-A- 3 712 537**

**Beschreibung**

STAND DER TECHNIK

Die Erfindung betrifft eine Selbsttesteinrichtung für Speicheranordnung, Decoder od.dgl. zur Anwendung im On-Line-Betrieb, wobei Mittel zur überprüfung einer Vielzahl von Wortleitungen vorgesehen sind.

Aus IEEE Trans. on Computer-Aided Design, vol. 9, No. 6, Juni 1990, S. 567 - 572, "A Realistic Fault Model and Test Algorithms for Static Random Access Memories", sind Verfahren zum Off-Line-Test von Speicheranordnungen bekannt. Diese Verfahren sind teilweise auch als "Built-in-self-Test" einsetzbar, aber wegen der sehr vielen erforderlichen Test-Pattern und der Zerstörung des Speicherinhalts nur bedingt für den Test im laufenden Betrieb (quasi on-line) einsetzbar. Darüber hinaus verbietet die erforderliche Testlänge den Einsatz im On-Line-Test.

Weiterhin sind aus "Defect and Fault Tolerance in VLSI Systems", in Koren, Plenum Press, New York, 1989 (Design of Fault-Tolerant DRAM with new on Chip ECC - Mazumber, P.) Anordnungen mit Codierung von Daten bekannt, wobei unterschiedliche Codes zur Anwendung kommen. Eine derartige Codierung verhindert jedoch nur einen sehr kleinen Teil von möglichen Hardwarefehlern in der zu überprüfenden Speicheranordnung.

Schließlich gibt es Verfahren, bei denen über einen ROM die tatsächlich ausgewählte Speicherzelle ermittelt und deren Adresse mit der gewünschten Adresse verglichen wird.

Dabei werden insbesondere Zeilen- und Spaltenadressen ausgelesen und mit der Eingangsadresse in einem Self-checking-checker verglichen. Derartige Verfahren sind beispielsweise aus "Self-checking Flash-EPROM", M. Nicolaidis, Beitrag zum Projekt JESSI SE 11, Präsentation zum Vortrag am 16.9.1992 in Grenoble, oder aus "Efficient ubist implementation for microprocessor sequencing parts", M. Nicolaidis, Juni 1990, Veröffentlichung des Instituts IMAG/TIM 3, 46 Avenue Félix Viallet, 38031 Grenoble, bekannt. Diese Selbsttesteinrichtungen sind jedoch schaltungstechnisch sehr aufwendig und decken für sich allein nur die Decoderfehler ab.

Aus US-A-3 712 537 ist eine Selbsttesteinrichtung von Speicheranordnungen bekannt, die eine defekte Wortleitung (zzB. 102), deren Pegel aufgrund eines defekten Wortleitungsschalters (52) ständig auf high liegt, dadurch identifiziert, daß während eines Testbetriebs, bei dem nacheinander die Pegel der übrigen Wortleitungen überprüft werden, festgestellt wird, daß alle diese Pegel auf high liegen. Eine gleichzeitige Überprüfung von mindestens zwei Wortleitungen auf high wie auch eine Durchführung der Überprüfung im On-Line-Betrieb sind nicht vorgesehen.

Insgesamt decken die bekannten Selbsttesteinrichtungen und -verfahren entweder jeweils für sich nur sehr wenige Fehlermöglichkeiten ab, oder sie sind sehr aufwendig bezüglich der erforderlichen Hardware oder sehr zeitaufwendig, so daß sie sich nicht für den On-Line-Betrieb eignen.

VORTEILE DER ERFINDUNG

Die erfindungsgemäße Selbsttesteinrichtung mit den kennzeichnenden Merkmalen des Hauptanspruchs hat demgegenüber den Vorteil, daß zur Überwachung der Wortleitungen lediglich ein sogenannter 1-aus-n-Prüfer eingesetzt wird, der im On-Line-Betrieb eine Fehlermeldung über einen Fehlerdetektor abgibt, wenn gleichzeitig mehr als eine Wortleitung aktiv ist. Dadurch werden zum einen die meisten Fehlerquellen im Decoder erfaßt, und zum anderen kann dieser Selbst test mit sehr geringem Aufwand und sehr schnell durchgeführt werden. Dabei können praktisch alle Adressierungsfehler erkannt werden, sofern durch die Codierung der Adresse mit einem geeigneten Code in Verbindung mit konstruktiven Regeln sowie einer Codeprüfung sichergestellt wird, daß ein Einzelfehler nicht zwei Wortleitungen in umgekehrter Richtung beeinflußt. Zusätzlich kann durch die Wahl des Datencodes sichergestellt werden, daß bei Aktivierung keiner Wortleitung ein fehlerhafter Code erkannt wird.

Durch die in den Unteransprüchen aufgeführten Maßnahmen sind vorteilhafte Weiterbildungen und Verbesserungen der im Hauptanspruch angegebenen Selbsttesteinrichtung möglich.

Eine bevorzugte Ausgestaltung des erfindungsgemäßen 1-aus-n-Prüfers besteht darin, daß jede Wortleitung in der Prüfmatrix jeweils mit Steueranschlüssen von z Schaltern einer Schaltermatrix verbunden ist, durch die z mit einem ersten Potential (Vdd) beaufschlagte Testleitungen entsprechend der Codierung der jeweiligen Wortleitung entweder mit ein zweites Potential (Vss) aufweisenden Anschlüssen oder mit einer Sensorleitung verbindbar sind, die ebenfalls mit dem ersten Potential (Vdd) beaufschlagt ist, wobei der Fehlerdetektor mit der Sensorleitung verbunden und als Strom- oder Spannungssensor ausgebildet ist. Sind zwei Wortleitungen gleichzeitig aktiv, so wird der Fehlerdetektor über zwei Schalter an das zweite Potential gelegt, so daß ein erhöhter Strom bzw. eine Veränderung des Potentials festgestellt werden kann.

Die Schalter der Schaltermatrix sind zweckmäßigerweise als FET-Transistoren ausgebildet, und die ein zweites Potential (Vss) aufweisenden Anschlüsse sind als Masseanschlüsse ausgebildet.

Zur Erhöhung der Prüfsicherheit wird die Prüfmatrix in vorteilhafter Weise selbst durch eine Prüfeinrichtung überprüft, die die Funktion der Schalter der Schaltermatrix testet. Dabei werden jeweils in größeren Abständen alle Schalter sequentiell geprüft.

Eine vorteilhafte Ausgestaltung dieser Prüfeinrichtung besteht darin, daß die Testleitungen in der Prüfeinrichtung mit Tristate-Treibern verbunden sind, durch die jeweils die mit dem zu überprüfenden und dazu angesteuerten Schalter verbundene Testleitung entsprechend der Schaltercodierung entweder auf das zweite Potential (Vss) legbar oder mit der Sensorleitung verbindbar ist. Hierdurch kann die Funktionsfähigkeit aller Schalter nacheinander getestet werden.

Zusätzlich können noch zweckmäßigerweise Mittel zum Übeprüfen von parallel zu den Wortleitungen angeordneten Versorgungsleitungen vorgesehen sein, die das erste (Vdd) und/oder das zweite Potential (Vss) führen. Die Überprüfung der mit dem zweiten Potential beaufschlagten Versorgungsleitungen kann ähnlich der Überprüfung der Schalter durch die Prüfeinrichtung erfolgen. Zur Überprüfung der mit dem ersten Potential (Vdd) beaufschlagten Versorgungsleitungen sind zusätzliche Schalter zur steuerbaren Verbindung der dieses erste Potential führenden Versorgungsleitungen mit der Sensorleitung vorgesehen, wobei diese Schalter durch die Wortleitungen und/oder durch zusätzliche Steuerleitungen steuerbar sind. Dabei wird nach der Entladung der Sensorleitung durch die Prüfung der das zweite Potential führenden Versorgungsleitungen bei hochohmigen Ausgangstreibern der Prüfeinrichtung das erneute Aufladen der Sensorleitung nach dem Durchsteuern der zusätzlichen Schalter geprüft.

Wird die Selbsttesteinrichtung bei Speicheranordnungen, beispielsweise RAM- oder ROM-Speichern, eingesetzt, so wird zweckmäßigerweise eine erste Prüfmatrix für die Zeilen-Leitungen und eine zweite Prüfmatrix für die SpaltenLeitungen eingesetzt.

Durch den erfindungsgemäßen 1-aus-n-Prüfer können Adressierungsfehler erkannt werden, die zur Aktivierung mehrerer Wortleitungen führen. Falsch angelegte Adressen und durch einen einzelnen Defekt vertauschte Wortleitungs/Spaltendecoderleitungen können dadurch nicht erkannt werden. Um auch diese Fehlermöglichkeiten zu erkennen, sind die Eingangsadressen codiert, und zur Überprüfung ist ein Codeprüfer vorgesehen. Wenn sich durch einen einzelnen Defekt allerdings der negierte und der unnegierte Wert eines Adressen-Bits ändern würde, so könnte der Codeprüfer und der 1-aus-n-Prüfer dies nicht erkennen. Um auch diese Fehlermöglichkeit zu erfassen, sind die von den einzelnen Adreßleitungen abzweigenden, unnegierten und die abzweigenden, durch einen Inverter negierten Leitungen beabstandet voneinander ohne gemeinsame Abzweigpunkte realisiert. Hierdurch wird praktisch ausgeschlossen, daß gleichzeitige Unterbrechungen zweier Leitungen durch einen Defekt entstehen. Der 1-aus-n-Prüfer kann dann eine derartige Leitungsunterbrechung erkennen. Besitzen alle an diesen Leitungen angeschlossenen Gatter den gleichen Eingangsschwellwert, das heißt, schalten alle diese Gatter einschließlich dem Codeprüfer bei dem gleichen Spannungspegel ihren Ausgangspegel um, so können auch Kurzschlüsse zwischen zwei Leitungen detektiert werden. Da diese Forderung nicht immer erreichbar ist, werden Dimensionierungsvorschriften für die Eingangsinverter der Adressenleitungen und die Decodergatter sowie der Codeprüfer beschrieben, durch die bei Kurzschlüssen zwischen negierten oder unnegierten Adressenleitungen entweder im Codeprüfer oder im 1-aus-n-Prüfer ein Fehler erkannt wird.

Eine noch größere Sicherheit kann dadurch erreicht werden, daß beide Inverter mit einer Stromüberwachungseinrichtung verbunden sind. Kurzschlüsse können dann direkt über einen erhöhten Strom durch die Stromüberwachungseinrichtung erkannt werden.

Eine noch vorteilhaftere Lösung besteht darin, daß von jeder Adreßleitung zunächst beabstandet voneinander und ohne gemeinsamen Abzweigpunkt die unnegierten Leitungen abzweigen, daß der Inverter für die negierten abzweigenden Leitungen in die Adreßleitung geschaltet ist, und daß vom negierten Bereich der Adreßleitung beabstandet voneinander und ohne gemeinsame Abzweigpunkte die negierten Leitungen abzweigen. Durch diese schärferen Design-Regeln kann erreicht werden, daß anstelle des 1-aus-n-Prüfers ein einfacherer Nachbarprüfer verwendet werden kann, der lediglich prüft, ob gleichzeitig zwei Wortleitungen aktiv sind, die benachbarten Adressen zugeordnet sind. Ein derartiger Nachbarprüfer ist beispielsweise aus "Error Detecting Codes, Self-checking Circles and Applications", J. Wakerly, Elsevier, North-Holland, 1978, bekannt.

ZEICHNUNG

Ausführungsbeispiele der Erfindung sind in der Zeichnung dargestellt und in der nachfolgenden Beschreibung näher erläutert. Es zeigen:

Fig. 1    ein Blockschaltbild einer Speicheranordnung mit Zeilenddecoder und Spaltendecoder,

Fig. 2    eine schematische Darstellung eines 1-aus-n-Prüfers,

Fig. 3    die schematische Darstellung einer Prüfeinrichtung für den 1-aus-n-Prüfer,

Fig. 4    das Schaltbild einer ROM-Zeile zur Überprüfung einer Vorladeleitung, des Leseverstärkers und der Lesesignale der Speicheranordnung,

Fig. 5    einen modifizierten 1-aus-n-Prüfer zur zusätzlichen Überprüfung von parallel zu den Wortleitungen angeordneten Versorgungsleitungen,

Fig. 6    die geometrische Anordnung von aus einer Adreßleitung abzweigenden unnegierten und negierten Leitungen,

Fig. 7    eine ähnliche Anordnung mit einer zusätzlichen Stromüberwachungseinrichtung,

Fig. 8    ein weiteres Ausführungsbeispiel der geometrischen Anordnung von aus einer einzelnen Adreßleitung abzweigenden negierten und unnegierten Leitungen,

Fig. 9    eine ähnliche Anordnung mit einer zusätzlichen Stromüberwachungseinrichtung und

Fig. 10   die schematisierte Darstellung eines Gatters in statischer CMOS-Technik.

BESCHREIBUNG DER AUSFÜHRUNGSBEISPIELE

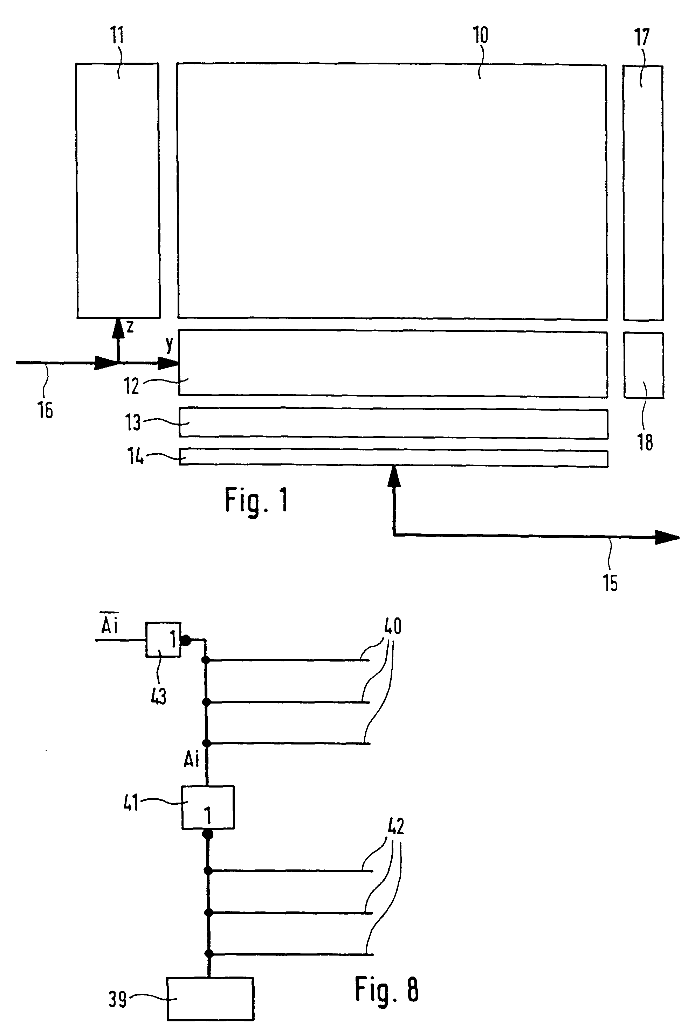

Die in Fig. 1 dargestellte Speicheranordnung ist beispielsweise ein RAM-Speicher und besteht in an sich bekannter Weise aus einer Speichermatrix 10, einem an dieser angeschlossenen Zeilendecoder 11 und einem entsprechend angeschlossenen Spaltendecoder 12. Der Spaltendecoder ist über einen Leseverstärker 13 und einen Signatur-Prüfer 14 mit einem Datenbus 15 zum Ein- und Auslesen von Daten verbunden. Ein Adressenbus 16 der Breite y + Z Bit, von denen z Bit zur Wortleitungsauswahl und y Bit zur Spaltenauswahl benutzt werden, ist mit dem Zeilendecoder 11 und dem Spaltendecoder 12 verbunden, um $n = 2^z$ Zeilenadressen und $p = 2^y$ Spaltenadressen anwählen zu können. Somit ist der Zeilendecoder 11 in nicht näher dargestellter Weise über n Zeilen- bzw. Wortleitungen und der Spaltendecoder 12 über m x p (m = Bitbreite des Datenwortes) Spaltenleitungen mit der Speichermatrix 10 verbunden. Den n Wortleitungen der Speichermatrix 10 ist ein 1-aus-n-Prüfer 17 und den p Spaltenleitungen, die im Spaltendecoder 12 generiert werden, ein entsprechender 1-aus-p-Prüfer zugeordnet.

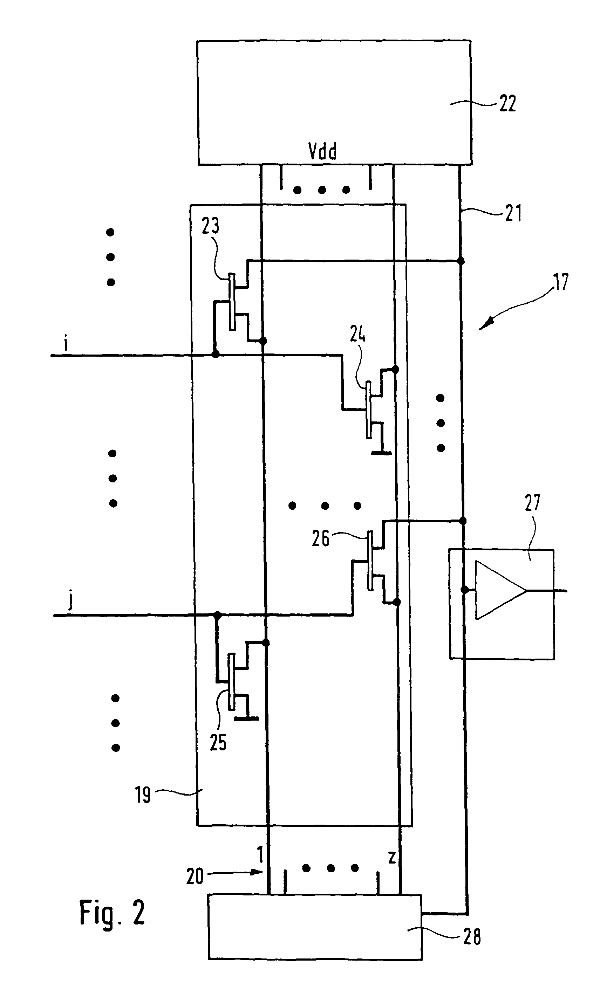

Der 1-aus-n-Prüfer 17 ist in Fig. 2 näher dargestellt. Von den n Zeilen- bzw. Wortleitungen sind zur Vereinfachung nur die beiden Wortleitungen i und j dargestellt. Die Wortleitungen erstrecken sich parallel in eine Schaltermatrix 19, in der senkrecht zu den n Wortleitungen z Testleitungen 20 verlaufen. Außerhalb der Schaltermatrix 19 verläuft noch eine Sensorleitung 21 parallel zu den Testleitungen 20. Die Testleitungen 20 und die Sensorleitung 21 werden von einer Vorladungs-Einrichtung 22 mit einem ersten Potential Vdd beaufschlagt. Jede Wortleitung ist durch FET-Transistoren anders codiert, wobei im Spezialfall die Codierung den Adreß-Bits der jeweiligen Wortleitung entsprechen kann. Jede Wortleitung steuert hierzu parallel z dieser FET-Transistoren an, die mit den z Testleitungen 20 verbunden sind. Zur Codierung verbindet der jeweilige FET-Transistor die Testleitung entweder mit der Sensorleitung 21 oder mit einem auf niedrigerem Potential Vss liegenden Anschluß, im Ausführungsbeispiel der Masseanschluß.

Beim dargestellten Ausführungsbeispiel weist die Codierung der Wortleitung i beispielsweise am Anfang eine 1 und am Ende eine 0 auf. Daher verbindet der entsprechende erste, der ersten Testleitung zugeordnete FET-Transistor 23 diese erste Testleitung 20 mit der Sensorleitung 21, während der letzte, also der z-te, FET-Transistor 24 die z-Testleitung mit Masse verbindet. Bei der Wortleitung j ist es umgekehrt, der erste FET-Transistor 25 verbindet dort die erste Testleitung mit Masse, und der letzte FET-Transistor 26 verbindet die z-Testleitung mit der Sensorleitung 21.

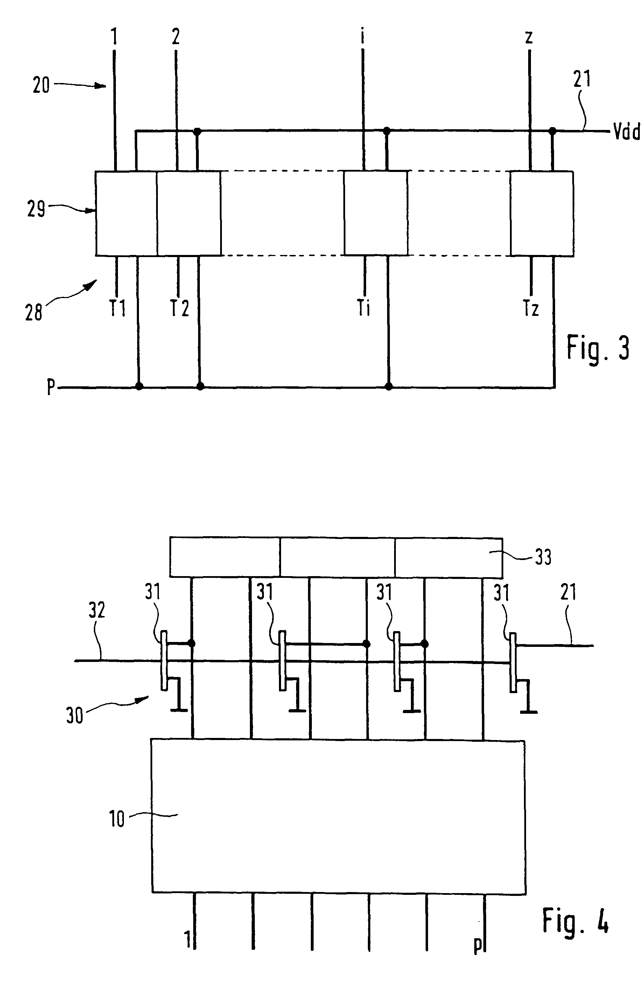

Die Sensorleitung 21 ist mit einem Stromsensor 27 verbunden, der mittelbar durch Veränderung des Potentials an der Sensorleitung 21 feststellt, ob ein Strom über die Testleitungen 20 zum niedrigeren Potential Vss (im Ausführungsbeispiel Masse) fließt. Weiterhin ist eine Prüfeinrichtung 28 mit den z-Testleitungen 20 und der Sensorleitung 21 verbunden, die in Zusammenhang mit Fig. 3 noch näher beschrieben wird.

Da in der Schaltermatrix 19 jede Wortleitung anders codiert ist, wird die auf das Potential Vdd vorgeladene Sensorleitung 21 entladen, wenn mehr als eine Wortleitung aktiv ist. Sind beispielsweise beide Wortleitungen i und j aktiv, so erfolgt sowohl eine Entladung der Sensorladung 21 über die Transistoren 23 und 25 als auch über die Transistoren 24 und 26. Da jede Wortleitung anders codiert ist, entsteht zwangsläufig immer eine Transistorkombination, die bei zwei aktiven Wortleitungen diese Entladung bewerkstelligt. Durch die Entladung wird im Stromsensor 27 ein Strom erkannt und in nicht näher dargestellter Weise eine Fehlermeldung abgegeben. Diese weist den Benutzer darauf hin, daß ein Fehler vorliegt.

Zur Prüfung der Spaltenadresse wird der entsprechend aufgebaute 1-aus-p-Prüfer 18 eingesetzt, mit dem Unterschied, daß anstelle von n Wortleitungen nunmehr p Spaltenleitungen geprüft werden.

In Fig. 3 ist die Prüfeinrichtung 28 näher dargestellt. Sie besteht im wesentlichen aus z Tristate-Treibern 29, wobei jeder Tristate-Treiber mit einer der Testleitungen 20 verbunden ist. Weiterhin ist die mit dem Potential Vdd beaufschlagte Sensorleitung 21 mit allen Tristate-Treibern 29 verbunden. Steuerseitig sind alle Tristate-Treiber 29 mit einem gemeinsamen Prüfsignal P sowie mit Einzelprüfsignalen Tl bis Tz beaufschlagt.

Mit Hilfe dieser Prüfeinrichtung 28 werden sämtliche FET-Transistoren 23 - 26 der Schaltermatrix 19 auf ihre Funktionsfähigkeit nacheinander getestet, wobei dieser Test sowohl nach einem Lese-/Schreibzugriff für die angesprochene Wortleitung erfolgen kann (einzelne Spalten oder alle nacheinander) oder vollständig in größeren Zeitabständen bei einer Betriebsunterbrechung der Speicheranordnung.

Die Überprüfung der mit der Sensorleitung 21 verbundenen Transistoren 23,26 wird am Beispiel des Transistors 23 erläutert. Zunächst werden Prüfsignale P und T1 erzeugt, durch die die erste mit dem Transistor 23 verbundene Testleitung auf das niedrige Potential Vss gelegt wird. Dann wird ein Steuersignal auf die Wortleitung i gelegt. Bei einwandfreier Funktion des Transistors 23 zieht dieser dadurch das Potential der Sensorleitung 21 auf Vss, so daß der Stromsensor 27 anspricht. Dieses Ansprechen bedeutet hier ein Bestätigungssignal für die ordnungsgemäße Funktion dieses Transistors 23.

Die Prüfung der mit Masse verbundenen Transistoren 24,25 wird am Beispiel des Transistors 24 erläutert. Durch entsprechende Prüfsignale P und Tz wird die z-Testleitung mit der Sensorleitung 21 verbunden. Wird nun ein Signal auf die Wortleitung i gelegt, so zieht wiederum bei ordnungsgemäßer Funktion der Transistor 24 das Potential der Sensorleitung 21 auf Vss, so daß der Stromsensor 27 anspricht. Auf diese Weise können nacheinander alle Transistoren durchgeprüft werden. Die Erzeugung der erforderlichen Prüfsignale P und T sowie der entsprechenden Signale auf den Wortleitungen erfolgt durch eine nicht dargestellte Signalfolgesteuerung bzw. einen nicht dargestellten Mikrorechner. Mit n x z Prüfschritten ist der gesamte 1-aus-n-Prüfer getestet. Die Überprüfung des 1-aus-p-Prüfers 18 kann parallel dazu durchgeführt werden.

Eine in Fig. 4 dargestellte ROM-Zeile 30 kann zusätzlich während Betriebsunterbrechungen zur Überprüfung der Vorladeleitung für die Speichermatrix 10, der Leseverstärker 13, der Lesesignale sowie der Nichtaktivität der Schreibsignale eingesetzt werden. Im Ausführungsbeispiel ist nur eine einzige ROM-Zeile 30 dargestellt, die aus vier FET-Transistoren 31 besteht, welche über eine gemeinsame Steuerleitung 32 ansteuerbar sind. Von den sechs dargestellten Spaltenleitungen sind drei - über drei der FET-Transistoren 31 - mit Masse verbindbar, während durch den vierten FET-Transistor 31 die Sensorleitung 21 mit Masse verbindbar ist. Die p-Spaltenleitungen (davon sind sechs dargestellt) werden von einer Vorladungs-Einrichtung 33 auf das Potential Vdd vorgeladen. Durch ein Signal auf der Steuerleitung 32 werden drei der Spaltenleitungen auf das Potential Vss heruntergezogen. Hierdurch wird durch diese ROM-Zeile 30 in jeder Spalte ein anderes Datenwort aktiviert, um die richtige Ansteuerung des Spaltendecoders und die korrekte Funktion des Leseverstärkers sowie der Ausgangsstufen zu testen. Es können selbstverständlich auch mehrere solcher ROM-Zeilen mit unterschiedlicher Codierung vorgesehen sein, wobei die durch diese ROM-Zeilen vorgegebenen Datenworte nicht notwendig Codeworte sein müssen für den Fall, daß die Daten codiert in dem Speicher abgelegt werden. Neben der Einzelprüfung einer Spalte ist die Möglichkeit gegeben, alle ROM-Datenworte nacheinander in einer festen Reihenfolge auszulesen und eine darüber gebildete Signatur mit einer abgespeicherten Soll-Signatur zu vergleichen. Dies erfolgt im in Fig. 1 dargestellten Signatur-Prüfer 14.

Im Normalfall sind die Vdd- und Vss-Versorgungsleitungen in der Speichermatrix 10 parallel zu den Bit-Leitungen (Spalten) geführt. Durch konstruktive Maßnahmen und die Bit-Belegung der Matrix ist dafür zu sorgen, daß die gleichen Versorgungsleitungen nicht für mehrere Bits des gleichen Datenworts benutzt werden. Diese Entkopplung ist konsequent bis zu den Ausgangsstufen der Speicheranordnung fortzuführen. Common-Mode-Fehler durch Einflüsse der Versorgungsspannungsleitungen in der Matrix werden dadurch vermieden. Es wird eine spaltenweise Versorgung vorausgesetzt, und der Spaltendecoder 12 selektiert die Daten-Bits für jede Bit-Stelle in der gleichen Reihenfolge.

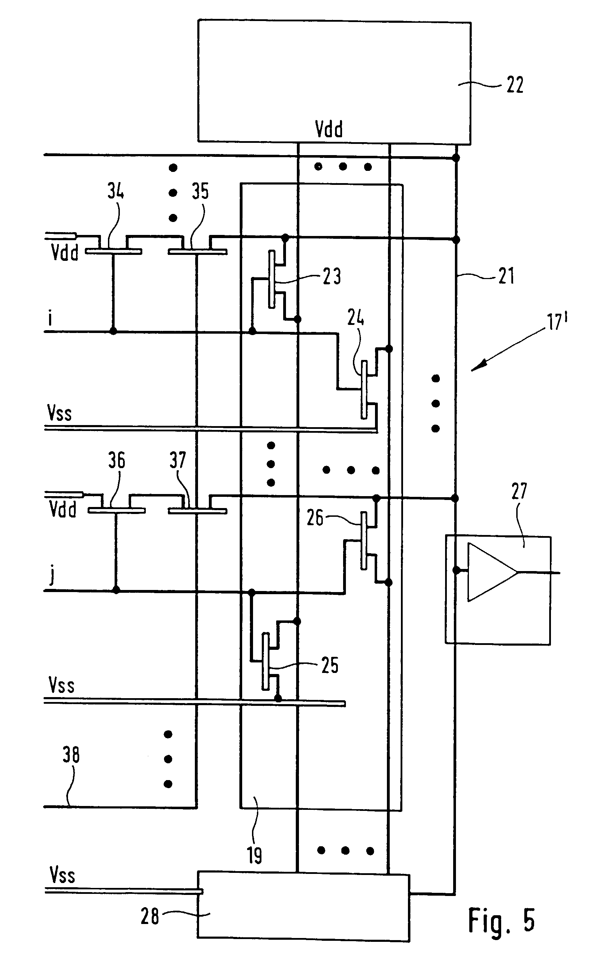

Sollten im Spezialfall Versorgungsleitungen parallel zu den Wortleitungen geführt sein, so ergibt sich die Möglichkeit der Prüfung durch die in Fig. 5 dargestellte Schaltung. Diese entspricht weitgehend der in Fig. 2 dargestellten Schaltung, wobei gleiche oder gleich wirkende Bauteile mit denselben Bezugszeichen versehen und nicht nochmals beschrieben sind. Man erhält einen modifizierten 1-aus-n-Prüfer 17'. Im Gegensatz zur Fig. 2 sind jetzt zwei Vss-Leitungen sowie zwei Vdd-Leitungen parallel zu den Wortleitungen i und j geführt (selbstverständlich auch zu den übrigen, nicht dargestellten Wortleitungen). Weiterhin ist eine Vss-Leitung zur Prüfeinrichtung 28 geführt. Jede Vdd-Leitung ist über die Reihenschaltung der Schaltstrecken zweier FET-Transistoren 34,35 bzw. 36,37 mit der mit der Sensorleitung 21 verbunden. Dabei werden die FET-Transistoren 34,36 durch die Wortleitungen i bzw. j und die FET-Transistoren 35,37 gemeinsam durch eine Steuerleitung 38 gesteuert.

Neben der Prüfung der Wortleitungen gemäß Fig. 2 kann hier noch zusätzlich eine Prüfung der Vdd- bzw. Vss-Leitungen erfolgen. Die Vss-Leitungen werden bis zu einem Verzweigungspunkt mitgeprüft, wenn nach der fehlerfreien Wortauswahl die Prüfeinrichtung 28 aktiviert wird. Dies erfolgt bei der Prüfung der Transistoren 24 und 25. Liegt der Verzweigungspunkt am Anfang der Speichermatrix 10, so wird die gesamte Zeile auf Unterbrechung der Vss- bzw. Masseleitung mitgeprüft. Für die Wortleitung mit der Adresse "1111...1" liegt kein Transistor an der Masseleitung, so daß diese durch Verbindung mit dem Masseanschluß der Prüfeinrichtung 28, also dem Masseanschluß der Tristate-Treiber, mitgeprüft werden kann. Zusätzlich können noch die Vdd-Leitungen mitgetestet werden. Dazu wird jeweils nach dem Vss-Test (entladene Sensorleitung 21) bei hochohmigen Tristate-Treibern 29 der Prüfeinrichtung 28 die Steuerleitung 38 aktiviert und das erneute Aufladen der Sensorleitung 21 über die Transistoren 34,35 bzw. 36, 37 (je nachdem, ob die Wortleitung i oder j aktiviert ist) geprüft.

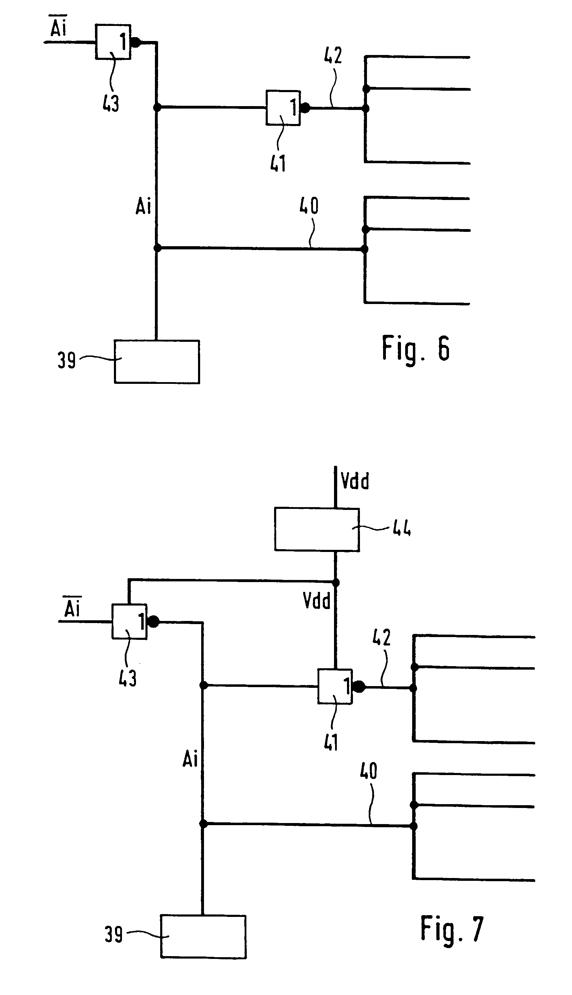

Grundlage für die bisherige Überprüfung der Speicheranordnung bzw. der Wortleitungen und Spaltenleitungen ist die Annahme, daß durch einen Fehler im Zeilen- bzw. Spaltendecoder 11,12 eine oder mehrere Wortleitungen bzw. Spaltenleitungen zusätzlich aktiviert werden. Nicht erkennbar sind dadurch Fehler, die auf einer falsch angelegten Adresse und auf einer durch einen einzelnen Defekt bewirkten Vertauschung von Wortleitungen/Spaltenleitungen beruhen. Zur Erkennung derartiger Fehler wird die Eingangsadresse z.B. durch ein Paritäts-Bit codiert, wobei eine Prüfung dieses Codes durch einen Codeprüfer erfolgt, der beispielsweise in dem Decoder enthalten sein kann. Zusätzlich sollten bestimmte geometrische Vorkehrungen getroffen werden, um zu verhindern, daß sich der negierte und der unnegierte Wert eines Adressen-Bits auf Grund eines einzelnen Fehlers ändern kann, ohne daß der Codeprüfer der Adresse diese Änderung bemerken kann. Dies wird durch die in Fig. 6 dargestellte Anordnung erreicht.

Dargestellt ist zur Vereinfachung nur eine einzelne Adressenleitung $\overline{Ai}$, die über den Eingangsinverter 43 die Adressenleitung Ai bildet, die zusammen mit anderen, nicht dargestellten Adressenleitungen zu einem Codeprüfer 39 geführt ist, um die Codierung der Eingangsadresse zu überprüfen. Hierdurch kann erkannt werden, ob die angelegte Adresse falsch ist. Von dieser Adressenleitung Ai zweigt ein unnegierte Leitung 40 und eine mittels eines Inverters 41 negierte Leitung 42 ab. Diese Leitungen verzweigen sich dann wieder in bekannter Weise und verlaufen zu den Gattern des Zeilen- bzw. Spaltendecoders 11,12. Die unnegierte Leitung 40 und die Leitung zum Inverter 41 werden in einem so großen Abstand voneinander gehalten, daß kein (Punkt-) Defekt diese gemeinsam so beeinflussen kann, daß beide ein anderes Potential annehmen können, als die Leitung zum Decoder 39, oder daß dies zumindest unwahrscheinlich ist. Dabei werden sternförmige Abzweigungen ausgeschlossen, das heißt, diese beiden Leitungen 40,42 werden von verschiedenen beabstandeten Stellen der Adressenleitung Ai abgezweigt.

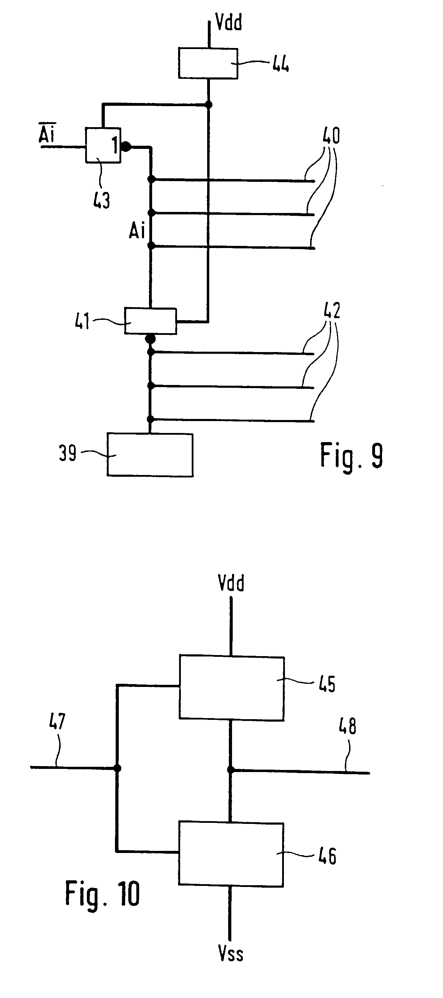

Die Inverter 41 und 43 und die nicht dargestellten Gatter an den verzweigten Leitungen 40 und 42 sowie der Codeprüfer 39 sind so dimensioniert, daß (z.B. bei einem Kurzschluß zwischen den Leitungen 40 und 42) alle angeschlossenen, nicht dargestellten Gatter an diesen Leitungen 40 und 42 und der Codeprüfer 39 den gleichen logischen Pegel erkennen, wenn genau ein Eingangssignal nicht auf hohem (Vdd) oder niedrigem (Vss) Potential liegt. Die nicht dargestellten an den Leitungen 40 und 42 angeschlossenen Gatter sowie der Codeprüfer 39 und die Inverter 41 und 43 sind beispielsweise in einer üblichen statischen Schaltungstechnik mit komplementären FET-Transistoren gemäß Fig. 10 realisiert (CMOS-Technik). Der P-Kanal-Zweig 45 schaltet in dieser Technik einen Strom zwischen dem oberen Potential Vdd und den Ausgang 48, wenn die betreffenden Eingänge - hier nur ein Eingang 47 dargestellt - auf niedrigem Potential (Vss) liegen. Der N-Kanal-Zweig 46 leitet demgegenüber einen Strom zwischen dem Ausgang 48 und dem niedrigen Potential (Vss), wenn die betreffenden Eingänge - hier als Eingang 47 dargestellt - ein hohes Potential (Vdd) besitzen.

Werden alle an die Leitungen 40 und 42 unmittelbar angeschlossenen Gatter, d.h. die nicht dargestellten Gatter und die Gatter im Codeprüfer, z.B. so realisiert, daß nur ein einziger Pfad im N-Kanal-Zweig 46 vom Ausgang 48 zum niedrigen Potential Vss existiert und ist dieser Pfad durch die Größe der Transistoren so dimensioniert, daß beim Umladen des Ausgangs 48 vom hohen Potential Vdd mehr Strom fließt als beim Umladen des Ausgangs 48 vom niedrigen Potential Vss durch genau einen beliebigen Pfad im P-Kanal-Zweig 45 bei anderer Eingangsbedingung 47, so muß für die Inverter 41 und 43 die Bedingung gelten, daß die Transistoren im P-Kanal-Zweig 45 zu Beginn der Umladung des Ausgangs 48 vom niedrigen Potential Vss mehr Strom liefern als die Transistoren im N-Kanal-Zweig 46 zu Beginn der Umladung des Ausgangs 48 vom hohen Potential Vdd. Diese Bedingung ist für alle Inverter 41 und 43 bei allen Adreßbits Ai gleichartig zu realisieren, ebenso wie für alle nicht dargestellten Gatter an den Leitungen 40 und 42 sowie den Codeprüfer 39 für alle Adreßbits Ai die gleichartige Dimensionierungsvorschrift gelten muß.

Durch die in Fig. 6 dargestellte Anordnung ist gewährleistet, daß durch einen Punktdefekt im allgemeinen nur eine Leitung abgetrennt oder in der beschriebenen Weise kurzgeschlossen werden kann, so daß auf Grund dieses Fehlers mehr als eine Wortleitung oder keine Wortleitung aktiviert wird, was wiederum durch den 1-aus-p-Prüfer 17, 17' erkannt werden kann.

Durch die in Fig. 7 dargestellte Anordnung kann man Kurzschlüsse zwischen den Leitungen noch sicherer erkennen. Beide Inverter 41,43 sind mit einem Stromsensor 44 verbunden. Wenn nun ein Kurzschluß zwischen einer negierten Leitung 42 und einer unnegierten Leitung 40 auftritt, so stellt der Stromsensor 44 eine erhöhte Stromentnahme durch die Inverter 41,43 fest, da diese ausgangsseitig dann gegeneinander arbeiten. Dieser festgestellte erhöhte Stromwert führt dann zu einer Fehlermeldung. Der Stromsensor kann der Leitung zum oberen Potential (Vdd) oder zum unteren Potential (Vss) zugeordnet werden.

In Fig. 8 ist eine weitere alternative geometrische Auslegung dargestellt. Hier ist der Inverter 41 in die Adressenleitung Ai geschaltet, und zwar zwischen mehreren Abzweigungen unnegierter Leitungen 40 und mehreren Abzweigungen negierter Leitungen 42. Dabei sind sowohl die negierten Leitungen 42 als auch die unnegierten Leitungen 40 untereinander beabstandet angeordnet und weisen jeweils eigene Abzweigpunkte von der Adressenleitung Ai auf, die ebenfalls beabstandet voneinander sind. Die an die Leitungen 40 und 42 angeschlossenen, nicht dargestellten Gatter und die unmittelbar angeschlossenen Gatter des Codeprüfers 39 einerseits und die Inverter 41 und 43 andererseits sind für alle Adreßleitungen Ai dimensioniert, wie bei der Schaltung von Fig. 6 beschrieben. Unter der Annahme einzelner Defekte von begrenzter Größe wird bei Einhaltung dieser geometrischen Regeln entweder eine Wortleitung/Spaltenleitung zusätzlich aktiv, deren Adresse sich um genau 1 Bit von der gewünschten Adresse unterscheidet, oder es wird überhaupt keine Wortleitung/Spaltenleitung aktiv. Beides wird von dem 1-aus-n-Prüfer 17, 17' bzw. 1-aus-p-Prüfer 18 erkannt. Da nur adressenmäßig nebeneinanderliegende Wortleitungen/Spaltenleitungen aktiv werden können, kann anstelle eines 1-aus-n-Prüfers auch ein einfacherer Nachbarprüfer verwendet werden, wie er im eingangs angegebenen Stand der Technik "Error Detecting Codes" beschrieben ist. Unterbrechungen der Wortleitung oder der Vorladeleitung werden miterkannt. Der Nachbarprüfer verlangt nicht nur weniger schaltungstechnischen Aufwand gegenüber dem 1-aus-n-Prüfer, sondern es ist auch ein deutlich verringerter Testaufwand für den Power-on-Test erforderlich, bei dem die anfängliche Fehlerfreiheit nachgewiesen werden muß.

In Fig. 9 ist die entsprechende Schaltung mit dem Stromsensor 44, ähnlich wie in Fig. 7, dargestellt.

Die beschriebene Selbsttesteinrichtung benötigt bei Codierung mit einem Paritätsbit lediglich einen zusätzlichen Gesamtaufwand an Chip-Fläche von ca. 15 %. Hiervon entfallen auf die Codierung (8-Bit-Datenwort und ein Paritätsbit) 12,5 % für den 1-aus-n-Prüfer bei vier KByte RAM mit 256 Zeilen und 128 Spalten (+ 16 Spalten Paritäts-Bits, + 8 Spalten Prüfer-ROM), bei einem Zeilen-Flächenverhältnis RAM : ROM = 10 zusätzlich ca. 0,6 %. Hinzu kommen Prüf-Hardware und Steuerung zusätzlich ca. 1 %, und der Aufwand für den Spaltenprüfer, den Zeilen-ROM, die Zusatz-Hardware und Steuerung beträgt insgesamt ca. 0,8 %. Demgegenüber würde eine Benutzung von zwei Code-Bits bereits einen Mehraufwand von 25 % bedeuten, wobei die Fehlerabdeckung ohne die zusätzlich beschriebenen erfindungsgemäßen Maßnahmen wesentlich schlechter wäre.

Es sei noch darauf hingewiesen, daß die beschriebene Selbsttesteinrichtung selbstverständlich auch für die verschiedensten Speicheranordnungen einsetzbar ist, wie z.B. Schreib-/Lesespeicher (RAM) und Nur-Lesespeicher (ROM, EPROM u.dgl.). Weiterhin kann diese Selbsttesteinrichtung auch allein für Decoder eingesetzt werden.

**Patentansprüche**

1. Selbsttesteinrichtung für Speicheranordnungen oder Decoder zur Anwendung im On-Line-Betrieb, wobei Mittel zur Überprüfung einer Vielzahl von Wortleitungen und/oder Spaltenleitungen vorgesehen sind, dadurch gekennzeichnet, daß die Wortleitungen und/oder Spaltenleitungen mit einer Prüfmatrix (17,18) verbunden sind, und daß ein bei gleichzeitig mehr als einer aktivierten Leitung ein Fehlersignal erzeugender Fehlerdetektor (27) mit der Prüfmatrix (17, 18) verbunden ist.

2. Selbsttesteinrichtung nach Anspruch 1, dadurch gekennzeichnet, daß jede Wortleitung und/oder Spaltenleitung in der Prüfmatrix (17,18) jeweils mit Steueranschlüssen von z Schaltern (23-26) einer Schaltermatrix verbunden ist, durch die z mit einem ersten Potential (Vdd) beaufschlagte Testleitungen (20) entsprechend der Codierung der jeweiligen Wortleitung und/oder Spaltenleitung entweder mit ein zweites Potential (Vss) aufweisenden Anschlüssen oder mit einer Sensorleitung (21) verbindbar sind, die ebenfalls mit dem ersten Potential (Vdd) beaufschlagt ist, wobei der Fehlerdetektor (27) mit der Sensorleitung (21) verbunden und als Strom- oder Spannungssensor ausgebildet ist.

3. Selbsttesteinrichtung nach Anspruch 2, dadurch gekennzeichnet, daß die Schalter (23-26) der Schaltermatrix als FET-Transistoren ausgebildet sind.

4. Selbsttesteinrichtung nach Anspruch 2 oder 3, dadurch gekennzeichnet, daß die ein zweites Potential (Vss) aufweisenden Anschlüsse als Masseanschlüsse ausgebildet sind.

5. Selbsttesteinrichtung nach einem der Ansprüche 2 bis 4, dadurch gekennzeichnet, daß eine Prüfeinrichtung (28) mit der Prüfmatrix (17,18) zur Überprüfung der Funktion der Schalter (23-26) der Schaltermatrix verbunden ist.

6. Selbsttesteinrichtung nach Anspruch 5, dadurch gekennzeichnet, daß alle Schalter (23-26) sequentiell geprüft werden.

7. Selbsttesteinrichtung nach Anspruch 5 oder 6, dadurch gekennzeichnet, daß die Testleitungen (20) in der Prüfeinrichtung (28) mit Tristate-Treibern (29) verbunden sind, durch die jeweils die mit dem zu überprüfenden und dazu angesteuerten Schalter (23-26) verbundene Testleitung (20) entsprechend der Schaltercodierung entweder auf das zweite Potential (Vss) legbar oder mit der Sensorleitung (21) verbindbar ist.

8. Selbsttesteinrichtung nach einen der Ansprüche 2 bis 7, dadurch gekennzeichnet, daß Mittel zum Überprüfen von parallel zu den Wortleitungen angeordneten Versorgungsleitungen vorgesehen sind, die das erste (Vdd) und/oder das zweite Potential (Vss) führen.

9. Selbsttesteinrichtung nach Anspruch 8, dadurch gekennzeichnet, daß zusätzliche Schalter (34-37) zur steuerbaren Verbindung der das erste Potential (Vdd) führenden Versorgungsleitungen mit der Sensorleitung (21) vorgesehen sind, und daß diese Schalter (34-37) durch die Wortleitungen/Spaltenleitungen und/oder durch eine zusätzliche Steuerleitung (38) steuerbar sind.

10. Selbsttesteinrichtung für Speicheranordnungen nach einem der vorhergehenden Ansprüche, dadurch gekennzeichnet, daß die Prüfmatrix (17) für die Wortleitungen und/oder eine zweite Prüfmatrix (18) für die Spaltenleitungen der Speichermatrix (10) der Speicheranordnung vorgesehen sind.

11. Selbsttesteinrichtung nach Anspruch 10, dadurch gekennzeichnet, daß wenigstens eine ROM-Zeile (30) zur überprüfung einer Vorladeleitung der Speicheranordnung, der Leseverstärker (13) und der Lesesignale während Betriebsunterbrechungen vorgesehen ist, wobei durch Schalter (31) der ROM-Zeile (30) in den Spalten feste Datenworte aktiviert werden, die auslesbar und überprüfbar sind.

12. Selbsttesteinrichtung nach Anspruch 10 oder 11, dadurch gekennzeichnet, daß die Speicheranordnung als Schreib-/Lesespeicher (RAM) oder als Nur-Lesespeicher (ROM) ausgebildet ist.

13. Selbsttesteinrichtung für Speicheranordnungen oder Decoder zur Anwendung im On-Line-Betrieb, wobei Mittel zur Überprüfung einer Vielzahl von Wortleitungen und/oder Decoderleitungen vorgesehen sind, dadurch gekennzeichnet, daß die Eingangsadressen codiert und zur Überprüfung ein Codeprüfer (39) vorgesehen sind, und daß die von den einzelnen Adreßleitungen (Ai) abzweigenden unnegierten (40) und die abzweigenden, durch einen Inverter (41) negierten Leitungen (42) beabstandet voneinander ohne gemeinsame Abzweigpunkte realisiert sind, daß die Wortleitungen mit einer Prüfmatrix (17,18) verbunden sind und daß ein bei gleichzeitig mehr als einer aktivierten Wortleitung oder bei gleichzeitig zwei aktivierten benachbarten Adressen zugeordneten Wortleitungen ein Fehlersignal erzeugender Fehlerdetektor mit der Prüfmatrix (17,18) verbunden ist.

14. Selbsttesteinrichtung nach Anspruch 13, dadurch gekennzeichnet, daß jede Adressenleitung auch eingangsseitig einen Inverter (43) aufweist, und daß beide Inverter (41,43) mit einer Stromüberwachungseinrichtung (44) verbunden sind.

15. Selbsttesteinrichtung nach Anspruch 13 oder 14, dadurch gekennzeichnet, daß von jeder Adressenleitung (Ai) zunächst beabstandet voneinander und ohne gemeinsame Abzweigpunkte die unnegierten Leitungen (40) abzweigen, daß der Inverter (41) für die negierten abzweigenden Leitungen (42) in die Adreßleitung (Ai) geschaltet ist und daß vom negierten Bereich der Adreßleitung (Ai) beabstandet voneinander und ohne gemeinsame Abzweigpunkte die negierten Leitungen (42) abzweigen.

16. Selbsttesteinrichtung nach Anspruch 12, dadurch gekennzeichnet, daß Speicherzellen, die zur Abspeicherung von verschiedenen Bits eines Speicherwortes benutzt werden, an unterschiedliche Versorgungsleitungen (Vdd und Vss) innerhalb der Speichermatrix (10) angeschlossen sind und daß diese Versorgungsleitungen nur außerhalb der Speichermatrix (10) miteinander elektrisch verbunden sind.

17. Selbttesteinrichtung nach Anspruch 16, dadurch gekennzeichnet, daß durch eine Codierung des Datenwortes die Unterbrechung einzelner Versorgungsleitungen (Vdd und Vss) innerhalb der Speichermatrix (10) erkannt wird.

18. Selbsttesteinrichtung nach einem der Ansprüche 13 bis 15, dadurch gekennzeichnet, daß durch eine Dimensionierungsvorschrift aller Inverter (41, 43) sowie aller unmittelbar an die Leitungen (40 und 42) angeschlossener Decodergatter und des Codeprüfers (39) für alle Adressen-bits (Ai) Kurzschlüsse zwischen zwei beliebigen Leitungen (40 und 42) entweder im Codeprüfer (39) oder in der Prüfmatrix (17, 18) erkannt werden.

**Claims**

1. Self-testing device for memory arrangements or decoders for application in on-line operation, means for checking a multiplicity of word lines and/or column lines being provided, characterized in that the word lines and/or column lines are connected to a test matrix (17, 18), and in that a defect detector (27), which generates a defect signal in the event of more than one activated line at the same time, is connected to the test matrix (17, 18).

2. Self-testing device according to Claim 1, characterized in that each word line and/or column line is connected in the test matrix (17, 18) in each case to control connections of z switches (23-26) of a switch matrix, by which z test lines (20), to which a first potential (Vdd) is applied, can be connected, in accordance with the coding of the respective word line and/or column line, either to terminals having a second potential (Vss) or to a sensor line (21), to which the first potential (Vdd) is likewise applied, the defect detector (27) being connected to the sensor line (21) and being designed as a current or voltage sensor.

3. Self-testing device according to Claim 2, characterized in that the switches (23-26) of the switch matrix are designed as FET transistors.

4. Self-testing device according to Claim 2 or 3, characterized in that the terminals having a second potential (Vss) are designed as earth terminals.

5. Self-testing device according to one of Claims 2 to 4, characterized in that a test device (28) is connected to the test matrix (17, 18) for checking the function of the switches (23-26) of the switch matrix.

6. Self-testing device according to Claim 5, characterized in that all of the switches (23-26) are tested sequentially.

7. Self-testing device according to Claim 5 or 6, characterized in that the test lines (20) are connected in the test device (28) to tristate drivers (29), by which the respective test line (20) connected to the switch (23-26) to be checked and driven for that purpose can, in accordance with the switch coding, either be put at the second potential (Vss) or be connected to the sensor line (21).

8. Self-testing device according to one of Claims 2 to 7, characterized in that means for checking supply lines which are arranged parallel to the word lines and carry the first potential (Vdd) and/or the second potential (Vss) are provided.

9. Self-testing device according to Claim 8, characterized in that additional switches (34-37) for the controllable connection of the supply lines carrying the first potential (Vdd) to the sensor line (21) are provided, and in that these switches (34-37) can be controlled by the word lines/column lines and/or by an additional control line (38).

10. Self-testing device for memory arrangements according to one of the preceding claims, characterized in that the test matrix (17) for the word lines and/or a second test matrix (18) for the column lines of the memory matrix (10) of the memory arrangement are provided.

11. Self-testing device according to Claim 10, characterized in that at least one ROM row (30) is provided for checking a precharge line of the memory arrangement, the sense amplifiers (13) and the read signals during interruptions of operation, fixed data words being activated in the columns by switches (31) of the ROM row (30), which data words can be read out and checked.

12. Self-testing device according to Claim 10 or 11, characterized in that the memory arrangement is designed as a read/write memory (RAM) or as a read-only memory (ROM).

13. Self-testing device for memory arrangements or decoders for application in on-line operation, means for checking a multiplicity of word lines and/or decoder lines being provided, characterized in that the input addresses are coded and a code checker (39) is provided for the purpose of checking, and in that the non-inverted lines (40) branching from the individual address lines (Ai) and the branching lines (42) inverted by an invertor (41) are realized such that they are spaced apart from one another without common branch points, in that the word lines are connected to a test matrix (17, 18), and in that a defect detector, which generates a defect signal in the event of more than one activated word line at the same time or in the event of two word lines assigned to neighbouring addresses being activated at the same time, is connected to the test matrix (17, 18).

14. Self-testing device according to Claim 13, characterized in that each address line also has an invertor (43) on the input side, and in that the two invertors (41, 43) are connected to a current monitoring device (44).

15. Self-testing device according to Claim 13 or 14, characterized in that the non-inverted lines (40) branch from each address line (Ai) initially in a manner spaced apart from one another and without common branch points, in that the invertor (41) for the inverted branching lines (42) is connected into the address line (Ai), and in that the inverted lines (42) branch from the inverted region of the address line (Ai) in a manner spaced apart from one another and without common branch points.

16. Self-testing device according to Claim 12, characterized in that memory cells which are used for storing different bits of a memory word are connected to different supply lines (Vdd and Vss) within the memory matrix (10), and in that these supply lines are electrically connected to one another only outside the memory matrix (10).

17. Self-testing device according to Claim 16, characterized in that the interruption of individual supply lines (Vdd and Vss) within the memory matrix (10) is identified by a coding of the data word.

18. Self-testing device according to one of Claims 13 to 15, characterized in that short circuits between two arbitrary lines (40 and 42) are identified, either in the code checker (39) or in the test matrix (17, 18), by virtue of a dimensioning specification of all the invertors (41, 43) and of all the decoder gates connected directly to the lines (40 and 42) and of the code checker (39) for all the address bits (Ai).

**Revendications**

1. Dispositif de contrôle automatique pour des mémoires ou décodeurs, destiné à des applications en ligne, comprenant des moyens pour contrôler un grand nombre de lignes de mots et/ou de lignes de colonnes,
caractérisé en ce que

   - les lignes de mots et/ou les lignes de colonnes sont reliées à une matrice de contrôle (17, 18) et
   - un détecteur d'erreur (27), générant simultanément un signal d'erreur de plus d'une ligne activée, est relié à la matrice de contrôle (17, 18).

2. Dispositif de contrôle automatique selon la revendication 1,
caractérisé en ce que
chaque ligne de mots et/ou ligne de colonnes, dans la matrice de contrôle (17, 18), est reliée chaque fois à des bornes de commande de Z interrupteurs (23-26) d'une matrice d'interrupteur par lesquels les Z lignes de contrôle (20) recevant un premier potentiel (Vdd) peuvent être reliées en fonction du codage de la ligne de mots respective et/ou de la lignes de colonnes, soit à des bornes qui sont à un second potentiel (Vss), soit à une ligne de capteurs (21), celle-ci étant également au premier potentiel (Vdd), le détecteur d'erreur (27) relié à la ligne de capteurs (21) étant réalisé comme capteur de courant ou de tension.

3. Dispositif de contrôle automatique selon la revendication 2,
caractérisé en ce que
les interrupteurs (23, 26) de la matrice d'interrupteurs sont des transistors FET.

4. Dispositif de contrôle automatique selon la revendication 2 ou 3,
caractérisé en ce que
les bornes, qui sont à un second potentiel (Vss), sont des bornes de masse.

5. Dispositif de contrôle automatique selon l'une des revendications 2 à 4,
caractérisé en ce qu'
une installation de contrôle (28) est reliée à la matrice de contrôle (17, 18) pour vérifier le fonctionnement des interrupteurs (23, 26) de la matrice d'interrupteurs.

6. Dispositif de contrôle automatique selon la revendication 5,
caractérisé en ce que
tous les interrupteurs (23, 26) sont contrôlés séquentiellement.

7. Dispositif de contrôle automatique selon les revendications 5 ou 6,
caractérisé en ce que
les lignes de contrôle (20) du dispositif de contrôle (28) sont reliées à des pilotes à trois états (29) par lesquels la ligne de contrôle, reliée chaque fois aux interrupteurs (23-26) à contrôler et commander à cet effet, en fonction du codage des interrupteurs, est mise soit au second potentiel (Vss), soit à la ligne de capteurs (21).

8. Dispositif de contrôle automatique selon l'une des revendications 2 à 7,
caractérisé par
des moyens pour contrôler des lignes d'alimentation prévues en parallèle aux lignes de mots qui conduisent le premier potentiel (Vdd) et/ou le second potentiel (Vss).

9. Dispositif de contrôle automatique selon la revendications 8,
caractérisé en ce que
des interrupteurs supplémentaires (34-37), prévus pour assurer une liaison commandée des lignes d'alimentation, sont au premier potentiel (Vdd) avec la ligne de capteurs (21) et ces interrupteurs (34-37) sont commandés par les lignes de mots/lignes de colonnes et/ou par une ligne de commande supplémentaire (38).

10. Dispositif de contrôle automatique pour des dispositifs à mémoire selon l'une des revendications précédentes, caractérisé par la matrice de contrôle (17) prévue pour les lignes de mots et/ou une seconde matrice (18) pour les lignes de colonnes de la matrice de mémoire (10) du dispositif de mémoire.

11. Dispositif de contrôle automatique selon la revendication 10,
caractérisé par

au moins une ligne ROM (30) pour contrôler une ligne de préchargement du dispositif à mémoire, l'amplificateur de lecture (13) et les signaux de lecture pendant les interruptions de fonctionnement,
les interrupteurs (31) de la ligne ROM (30) activant des mots de données dans les colonnes fixes, mots qui peuvent être lus et contrôlés.

12. Dispositif de contrôle automatique selon les revendication 10 ou 11,
caractérisé en ce que
le dispositif de mémoire est une mémoire écriture/ lecture (RAM) ou une mémoire à lecture seule (ROM).

13. Dispositif de contrôle automatique pour des dispositifs de mémoire ou décodeurs, destiné à des applications en lignes, avec des moyens pour contrôler un grand nombre de lignes de mots et/ou de lignes de décodeurs,
caractérisé en ce que

- les adresses d'entrée sont codées et pour le contrôle il est prévu un contrôleur de code (39),
- les lignes (40), sans négation, qui partent des différentes lignes d'adresses (Ai) et les lignes (42) avec négation par un inverseur (41) qui en partent, sont écartées l'une de l'autre sans points de dérivation communs,

- les lignes de mots sont reliées à une matrice de contrôle (17, 18) et

- lorsque simultanément plus d'une ligne de mots est activée ou que simultanément deux lignes de mots associées à deux adresses voisines sont activées, un détecteur d'erreur, qui génère un signal d'erreur, est relié à la matrice de contrôle (17, 18).

**14.** Dispositif de contrôle automatique selon la revendication 13, caractérisé en ce que

chaque ligne d'adresses comporte également en entrée un inverseur (43) et les deux inverseurs (41, 43) sont reliés à une installation de surveillance de courant (44).

**15.** Dispositif de contrôle automatique selon la revendication 13 ou 14, caractérisé en ce que

- les lignes sans négation (40) dérivent de chaque ligne d'adresses (Ai) tout d'abord, écartées l'une de l'autre, et sans point de dérivation commun,

- l'inverseur (41) est branché dans la ligne d'adresses (Ai) pour les lignes (42) à négation, qui dérivent, et

- les lignes à négation (42) dérivent de la zone de négation de la ligne d'adresses (Ai), de manière écartée et sans point de dérivation commun.

**16.** Dispositif de commande automatique selon la revendication 12, caractérisé en ce que des cellules de mémoire, utilisées pour mettre en mémoire différents bits d'un mot de mémoire, sont raccordées à des lignes d'alimentation différentes (Vdd) et (Vss) à l'intérieur de la matrice de mémoire (10) et ces lignes d'alimentation ne sont reliées électriquement entre elles qu'à l'extérieur de la matrice de mémoire (10).

**17.** Dispositif de contrôle automatique selon la revendication 16, caractérisé en ce que par un codage du mot de donnée on reconnaît l'interruption des différentes lignes d'alimentation (Vdd et Vss) à l'intérieur de la matrice de mémoire (10).

**18.** Dispositif de contrôle automatique selon l'une des revendications 13 à 15, caractérisé par une prescription de dimensionnement de tous les inverseurs (41, 43) ainsi que de toutes les portes de décodeurs raccordées directement aux lignes (40 et 42) et du contrôleur de code (39) pour tous les bits d'adresses (Ai), on reconnaît les courts-circuits entre deux lignes quelconques (40, 42), soit dans le contrôleur de code (39), soit dans la matrice de contrôle (17, 18).

Fig. 1

Fig. 8

Fig. 2

Fig. 3

Fig. 4

Fig. 5

Fig. 6

Fig. 7

Fig. 9

Fig. 10